Europäisches Patentamt

European Patent Office

Office européen des brevets

(11) Veröffentlichungsnummer: **0 061 520**
**B2**

(12) **NEUE EUROPÄISCHE PATENTSCHRIFT**

(45) Veröffentlichungstag der neuen Patentschrift:
**17.10.90**

(51) Int. Cl.⁵: **G 01 R 15/02**

(21) Anmeldenummer: **81108625.5**

(22) Anmeldetag: **21.10.81**

(54) Magnetkernloser Messwandler zum berührungslosen Messen eines Messstromes.

(30) Priorität: **26.03.81 CH 2038/81**

(43) Veröffentlichungstag der Anmeldung:
**06.10.82 Patentblatt 82/40**

(45) Bekanntmachung des Hinweises auf die
Patenterteilung:
**11.09.85 Patenblatt 85/37**

(45) Bekanntmachung des Hinweises auf die
Entscheidung über den Einspruch:
**17.10.90 Patentblatt 90/42**

(84) Benannte Vertragsstaaten:
**DE FR GB IT NL**

(56) Entgegenhaltungen:
EP-A-0 030 041
EP-A-0 054 626
DE-A-2 333 514
FR-A-2 458 136

ELEKTROTECHNIK, Band 50, nr. 19, 2. Oktober
1968, Seiten 304-308 Würzburg, DE. U.
KIRSCHNER: "Der Hall-Effekt in der elektrischen
Messtechnik"

Die Akte enthält technische Angaben, die nach
dem Eingang der Anmeldung eingereicht
wurden und die nicht in dieser Patentschrift
enthalten sind.

(73) Patentinhaber: **LGZ LANDIS & GYR ZUG AG
CH-6301 Zug (CH)**

(72) Erfinder: **Lienhard, Heinz
Neufrauenstein 12
CH-6300 Zug (CH)**

(74) Vertreter: **Müller, Hans-Jürgen, Dipl.-Ing. et al
Müller, Schupfner & Gauger Maximilianstrasse 6
Postfach 10 11 61
D-8000 München 1 (DE)**

(56) Entgegenhaltungen:

IEEE Transactions on Magnetics, Vol. MAG-12,
No. 6, November 1976, Seiten 813-815

Courier Press, Leamington Spa, England.

**Beschreibung**

Die Erfindung bezieht sich auf einen magnetkernlosen Meßwandler der im Oberbegriff des Anspruchs 1 genannten Art. Ein solcher ist bereits aus IEEE Transactions on Magnetics, 1976, Seiten 813 bis 815, bekannt. Dabei sind zwei Paar Magnetfeldsensoren in Nachbarschaft eines Steges eines U-förmigen Flachleiters anzuordnen, um durch entsprechende Zuordnung der Paare der Magnetfeldsensoren innerhalb des linearen Teiles der Magnetisierungskennlinie zu bleiben. Dabei ist es jeoch erforderlich, die einzelnen Magnetfeldsensoren in einem besonderen Schichtenaufbau herzustellen.

Außerdem ist ein magnetkernloser Meßwandler bekannt (GB—A—2 000 873), bei dem der Magnetfeldsensor mittels eines Hilfsmagnetfeldes abwechseln in beide Sättigungsrichtungen magnetisiert wird und ein Pulssignal liefert, das ein zeitverschlüsseltes Maß für den Meßstrom darstellt. Der Magnetfeldsensor befindet sich in der Nähe eines Schenkels. Ferner ist ein Meßwandler mit einem Ring- oder Stabkern bekannt (DE—A—23 33 514), bei dem zur digitalen Gleichstrommessung Ausgangsimpulse erzeugt werden, deren Zeitabstand das Meßergebnis darstellt.

Der Magnetfeldsensor solcher Meßwandler reagiert naturgemäß nicht nur auf das vom Meßstrom erzeugte Magnetfeld, sondern auch auf irgendwelche extern generierte Magnetfelder. Solche Fremdfelder bewirken einen Meßfehler, was bedingt, die Meßwandler sorgfältig gegen Fremdfehler abzuschirmen.

Bei einem aus der Zeitschrift Elektrotechnik, Band 50, Nr. 19. 1968, Seiten 304—308, bekannten Meßwandler zur Messung hoher Gleichströme wird der störende Einfluß von Fremdfeldern dadurch eliminiert, daß in zwei Luftspalten eines Eisenkerns in der gleichen Ebene je ein Hall-Generator angeordnet wird und die Hall-Spannungen der beiden Hall-Generatoren in Serie geschaltet werden.

Der im Anspruch 1 angegebenen Erfindung liegt die Aufgabe zugrunde, einen magnetkernlosen Meßwandler der eingangs genannten Art zu schaffen, bei dem Fremdfeldeinflüsse derart kompensiert werden, daß es praktisch unmöglich ist, extern einen das Meßresultat beeinflussenden Magnetfeldgradienten zu erzeugen.

Weiterbildungen der Erfindung sind in den Ansprüchen 2 bis 6 angegeben.

Nachfolgend werden zwei Ausführungsbeispiele der Erfindung anhand der Zeichnung näher erläutert. In den Fig. 1 bis 6 werden prinzipielle Merkmale gezeigt, die zur Erfindung führen. Dabei zeigt

Fig. 1 einen Flachleiter,
Fig. 2 einen Meßwandler,
Fig. 3 einen Meßwandler im Schnitt,
Fig. 4 den Meßwandler nach der Fig. 3 in der Draufsicht,
Fig. 5 ein Diagramm,
Fig. 6 ein Blockschaltbild eines Meßkreises,
Fig. 7 einen Meßwandler nach der Erfindung im Schnitt,
Fig. 8 den Meßwandler nach der Fig. 7 in der Draufsicht,
Fig. 9 eine weitere Ausbildungsform eines Meßwandlers nach der Erfindung im Schnitt,
Fig. 10 den Meßwandler nach der Fig. 9 in perspektivischer Darstellung und
Fig. 11 ein Diagramm.

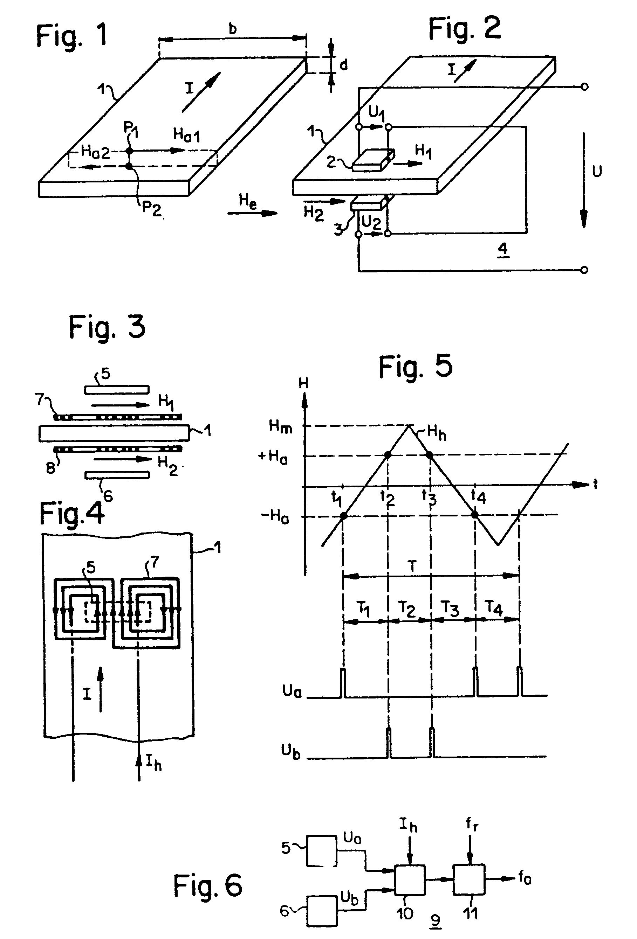

Gemäß Fig. 1 ist die Dicke d des elektrischen Flachleiters 1 klein im Vergleich zur Breite b. Ein in Längsrichtung des Flachleiters 1 fließender Meßstrom I erzeugt ein magnetisches Außenfeld, das in einem Punkt $P_1$ auf der oberen Flachseite in der Mitte des Flachleiters 1 mit $H_{a1}$ und in einem gegenüberliegenden Punkt $P_2$ mit $H_{a2}$ bezeichnet ist. Geht man vom Punkt $P_1$ zum Punkt $P_2$, so ändert sich das Außenfeld vom Wert $H_{a1}$ zum Wert $H_{a2}$; dabei gilt

$$H_a = H_{a1} = -H_{a2} \cong \frac{I}{2d}.$$

Je näher der Punkt $P_1$ beim Punkt $P_2$ liegt, das heißt, je dünner der Flachleiter 1 ist, desto schwieriger ist es, einen solchen Feldgradienten extern zu erzeugen. Diese Tatsache wird hier ausgenützt, um den störenden Einfluß von Fremdfeldern zu kompensieren.

Der Meßwandler nach der Fig. 2 besteht aus dem Flachleiter 1, zwei Magnetfeldsensoren 2, 3 und einem Meßkreis 4. Die Magnetfeldsensoren 2, 3 sind nahe an der Oberfläche des Flachleiters 1 so angeordnet, daß der Magnetfeldsensor 2 das Außenfeld $H_{a1}$ im Punkt $P_1$ und der Magnetfeldsensor 3 das entgegengesetzt gerichtete Außenfeld $H_{a2}$ im Punkt $P_2$ erfaßt.

Wirkt in Richtung des Außenfeldes $H_{a1}$ ein extern erzeugtes magnetisches Fremdfeld $H_e$ auf den Meßwandler ein, so erfaßt der Magnetfeldsensor 2 das Magnetfeld

$$H_1 = H_a + H_e$$

und der Magnetfeldsensor 3 das Magnetfeld

$$H_2 = -H_a + H_e.$$

2

Die Magnetfeldsensoren 2, 3 weisen eine wenigstens annähernd lineare Übertragungskennlinie auf und liefern ein Ausgangssignal $U_1$ bzw. $U_2$, für das gilt:

$$U_1 = k \cdot H_1$$

$$U_2 = k \cdot H_2$$

Im Meßkreis 4 werden die Ausgangssignale $U_1$ und $U_2$ so überlagert, daß eine zur Differenz der Ausgangssignale $U_1$ und $U_2$ proportionale Ausgangsspannung U entsteht und der Einfluß des Fremdfeldes $H_e$ auf das Meßresultat selbsttätig kompensiert wird. Im dargestellten Beispiel sind die Magnetfeldsensoren 2, 3 in Reihe geschaltet, so daß gilt:

$$U = U_1 - U_2 = k(H_1 - H_2) = k[(H_a + H_e) - (-H_a + H_e)] = k2H_a.$$

In der nicht maßstäblich gezeichneten Fig. 3 bedeuten 5, 6 zwei Magnetfeldsensoren, die eine nichtlineare Übertragungskennlinie aufweisen und wiederum das Magnetfeld $H_1$ bzw. $H_2$ im Punkt $P_1$ bzw. $P_2$ (Fig. 1) erfassen. Zwei Flachspulen 7, 8 die von einem alternierenden Hilfsstrom $I_h$ (Fig. 4) durchflossen werden und im dargestellten Beispiel zwischen dem Flachleiter 1 und dem Magnetfeldsensor 5 bzw., 6 angeordnet sind, erzeugen je ein magnetisches Hilfsfeld $H_h$, das gemäß der Fig. 5 einen dreieckförmigen Verlauf aufweist. Auf den Magnetfeldsensor 5 wirkt das Magnetfeld

$$H_1 = H_h + H_a + H_e$$

und auf den Magnetfeldsensor 6 das Magnetfeld

$$H_2 = H_h - H_a + H_e$$

ein. Die Flachspulen 7, 8 können gemäß der Fig. 4 als gewickelte oder in Dünnfilmtechnik hergestellte Doppelspulen hergestellt sein.

Die Arbeitsweise des beschriebenen Meßwandlers wird im folgenden anhand des Diagramms der Fig. 5 erläutert. Der Magnetfeldsensor 5 liefert jeweils im Nulldurchgang des Magnetfeldes $H_1$ einen Impuls (Signal $U_a$) und der Magnetfeldsensor 6 im Nuldurchgang des Magnetfeldes $H_2$ einen Impuls (Signal $U_b$). Ist kein Fremdfeld $H_e$ vorhanden, so schaltet der Magnetfeldsensor 5 in den Zeitpunkten $t_1$ und $t_4$, wenn $H_h = -H_a$ ist, und der Magnetfeldsensor 6 in den Zeitpunkten $t_2$ und $t_3$, wenn $H_h = +H_a$ ist. Es gilt

$$T_1 = t_2 - t_1 = T_3 = t_4 - t_3 = H_a \cdot \frac{T}{2H_m}$$

wobei T die Periodendauer und $H_m$ die Amplitude des Hilfsfeldes $H_h$ bedeutet. Der Zeitabstand $T_1$ bzw. $T_3$ zwischen einem Impuls $U_a$ des Magnetfeldsensors 5 und einem Impuls $U_b$ des Magnetfeldsensors 6 ist also zum Außenfeld $H_a$ und damit zum Meßstro I proportional.

Ein Fremdfeld $H_e$ bewirkt im Diagramm der Fig. 5 eine Verschiebung der Dreieckkurve $H_h$ nach oben oder unten. Dadurch verschieben sich die Zeitpunkte $t_1$ und $t_2$ im Diagramm beispielsweise nach links und die Zeitpunkte $t_3$ und $t_4$ in gleichem Maße nach rechts, was jedoch auf die Zeitabstände $T_1$ und $T_3$ keinen Einfluß hat. Diese Zeitabstände sind also gegenüber dem Fremdfeld $H_e$ invariant. Die Zeitabstände $T_2$ und $T_4$ sind dagegen vom Fremdfeld $H_e$ abhängig, ändern jeweils gegenläufig und können zu einer Überwachung von Fremdfeldern beigezogen werden.

In der Fig. 6 ist ein Meßkreis 9 dargestellt, der an die Magnetfeldsensoren 5, 6 angeschlossen ist und aus einer Schaltlogik 10 und einem Gatter 11 besteht. In der ansteigenden Halbperiode des Hilfsstromes $I_h$ öffnet die Schaltlogik 10 das Gatter 11 bei einem Impuls $U_a$ des Magnetfeldsensors 5 und schließt es wieder beim nächsten Impuls $U_b$ des Magnetfeldsensors 6. Bei abfallendem Hilfsstrom $I_h$ wird das Gatter 11 durch einen Impuls $U_b$ des Magnetfeldsensors 6 geöffnet und durch einen Impuls $U_a$ des Magnetfeldsensors 5 gesperrt. Während den Zeitabständen $T_1$ und $T_3$, in denen das Gatter 11 geöffnet ist, werden die Impulse einer Referenzfrequenz f, an den Ausgang des Meßkreises 9 durchgeschaltet. Der zeitliche Mittelwert der Ausgangsfrequenz $f_a$ ist zum Meßstrom I proportional.

Das dem Meßwandler nach der Fig. 2 und jenem nach den Fig. 3 bis 6 zugrunde liegende gemeinsame Prinzip ist nun leicht erkennbar. In beiden Fällen sind zwei Magnetfeldsensoren vorgesehen, von denen der eine einem Außenfeld und der andere diesem nunmehr entgegengesetzt gerichteten Außenfeld ausgesetzt ist, und die Signale der Magnetfeldsensoren werden im Meßkreis so ausgewertet, daß ein auf den einen Magnetfeldsensor einwirkendes Fremdfeld das Ausgangssignal des Meßkreises — im einen Fall die Spannung U, im anderen Fall die Zeitabstände $T_1$ und $T_3$ bzw. Ausgangsfrequenz $f_a$ — vergrößert, während

3

das gleiche, auf den anderen Magnetfeldsensor einwirkende Fremdfeld das Ausgangssignal des Meßkreises im gleichen Maße verkleinert.

Allgemein werden also mittels der beiden Magnetfeldsensoren 2, 3 bzw. 5, 6 Meßwerte $s^+$ und $s^-$ ermittelt, für die gilt

$$s^+ \sim H_a + H_e$$

$$s^- \sim -H_a + H_{e\prime}$$

und im Meßkreis 4 bzw. 9 wird aus diesen Meßwerten der Ausgangsmeßwert

$$s = (s^+ - s^-) \sim 2 H_a$$

gebildet.

Dieses Prinzip läßt sich auch anwenden, wenn der Hilfsstrom $I_h$ und damit das Hilfsfeld $H_h$ nicht einer deterministischen sondern einer stochastischen Funktion folgt. Hierbei liefern die Magnetfeldsensoren 5, 6 stochastische Signale $s^+$ und $s^-$, deren mathematische Erwartung E ein Maß für das Außenfeld $H_a$ und das Fremdfeld $H_e$ darstellt:

$$E\{s^+\} \sim H_a + H_e$$

$$E\{s^-\} \sim -H_a + H_e.$$

Aus diesen Signalen wird im Meßkreis ein Ausgangssignal gebildet, für das gilt:

$$E\{s\} = E\{s^+ - s^-\} \sim 2H_a.$$

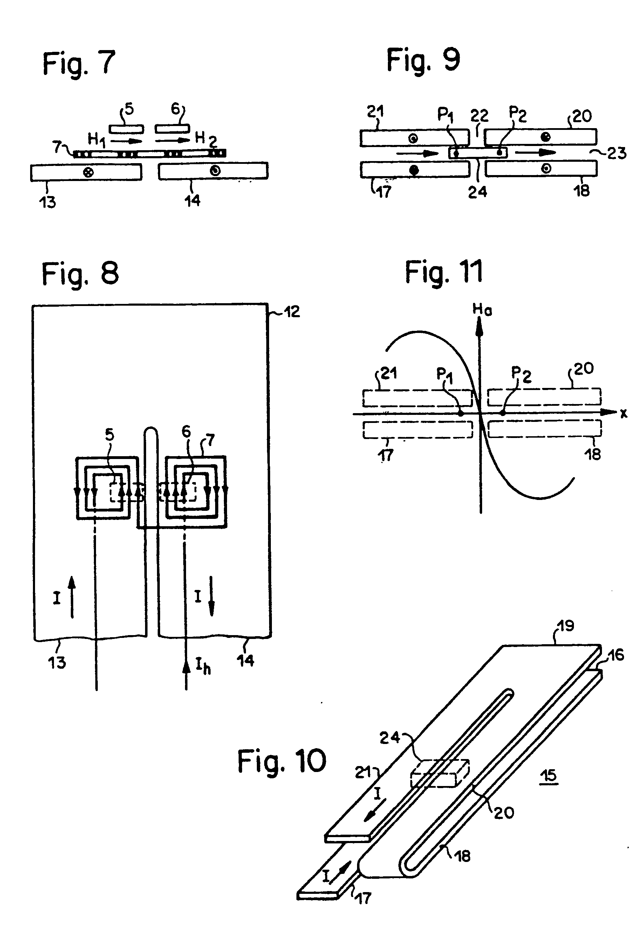

Die in Fig. 2 bis 4 beschriebenen Ausführungsbeispiele erfordern zwei voneinander getrennte Magnetfeldsensoren auf verschiedenen Substraten. Das Ausführungsbeispiel nach den Fig. 7 und 8 weist zur Vermeidung dieses Nachteils dagegen einen U-förmigen Flachleiter 12 mit zwei parallelen, in einer gemeinsamen Ebene liegenden Schenkeln 13, 14 auf. Der Magnetfeldsensor 5 ist auf dem Schenkel 13 und de Magnetfeldsensor 6 auf dem Schenkel 14 angeordnet. Beide Magnetfeldsensoren 5, 6 liegen in einer gemeinsamen Ebene auf der gleichen, in der Zeichnung oberen, Flachseite des Flachleiters 12. Sie können auf einem gemeinsamen, nicht gezeichneten Substrat angeordnet sein. Zur Erzeugung des Hilfsfeldes $H_h$ genügt eine einzige Flachspule 7, die z. B. zwischen dem Flachleiter 12 und den Magnetfeldsensoren 5, 6 liegen und als rechteckspiralförmige Doppelspule oder Einfachspule ausgebildet und auf dem gleichen Substrat wie die Magnetfeldsensoren 5, 6 angeordnet sein kann. Auch bei dieser Anordnung ist der Magnetfeldsensor 5 einem Magnetfeld $H_1 = H_h + H_a + H_e$ und der Magnetfeldsensor 6 einem Magnetfeld $H_2 = H_h - H_a + H_e$ ausgesetzt.

In den Fig. 9 und 10 ist ein Meßwandler mit einem Flachleiter 15 dargestellt, der aus einem U-förmigen Teil 16 mit zwei parallelen, in einer ersten gemeinsamen Ebene liegenden Schenkeln 17, 18 und einem U-förmigen Teil 19 mit zwei parallelen, in einer zur ersten Ebene parallelen zweiten gemeinsamen Ebene liegenden Schenkeln 20, 21 besteht, wobei das Ende des Schenkels 18 mit dem Ende des Schenkels 20 verbunden ist. Zwischen den Schenkeln 17 und 18 bzw. 20 und 21 befindet sich ein Spalt 22 und zwischen den Schenklen 17 und 21 bzw. 18 und 20 ein Spalt 23. Der Flachleiter 15 bildet eine bifilare Wirkung und kann aus einem einzigen Stanzteil geformt werden, indem die ineinander übergehenden Enden der Schenkel 18, 20 U-förmig abgebogen werden.

Im Spalt 23 ist eine Sensoreinheit 24 angeordnet, welche die beiden Magnetfeldsensoren 5, 6 (Fig. 7) und gegebenenfalls die Flachspule 7 enthält, wobei der Magnetfeldsensor 5 im Punkt $P_1$ zwischen dem Schenkel 17 und dem Schenkel 21 und der Magnetfeldsensor 6 im Punkt $P_2$ zwischen dem Schenkel 18 und dem Schenkel 20 angeordnet ist.

In der Fig. 11 ist das Außenfeld $H_a$ als Funktion des Ortes x innerhalb des Spaltes 23 dargestellt. Es ist ersichtlich, daß die Kurve $H_a = f(x)$ im Spalt 22 sehr steil verläuft und von $+H_a$ auf $-H_a$ wechselt. Dies gestattet, die Punkte $P_1$ und $P_2$ nahe an den Spalt 22 zu legen und somit die Magnetfeldsensoren 5, 6 in geringem Abstand voneinander anzuordnen.

Der Meßwandler nach den Fig. 9 und 10 hat gegenüber dem Meßwandler nach den Fig. 7 und 8 den Vorteil, daß das Außenfeld $H_a$ bei gleich großem Meßstrom I doppelt so stark ist, daß die Induktivität des Flachleiters infolge seiner bifilaren Ausgestaltung geringer ist und daß im Meßwandler erzeugten Magnetfelder weniger stark nach außen abstrahlen.

Als Magnetfeldsensoren 2, 3 bzw. 5, 6 eignen sich vorzugsweise magnetoresistive Dünnfilme aus anisotropischem ferromagnetischem Material. Diese können in der leichten oder in der harten Magnetachse betrieben werden, je nachdem, ob sie ein lineares oder nichtlineares Verhalten zeigen sollen. Sie können zusammen mit der Flachspule 7 bzw. 8 in integrierter Schaltungstechnik ausgeführt werden. Zur Erzielung eines streng linearen Verhaltens können mehrere magnetoresistive Dünnfilme zu einer

## EP 0 061 520 B2

elektrischen Brücke geschaltet werden. Der Meßwandler nach der Fig. 2 kann als sogenannter kompensierter Wandler ausgebildet werden, indem das Außenfeld $H_a$ mittels eines Verstärkers und einer Hilfsspule kompensiert wird. Als Magnetfeldsensoren eignen sich z. B. auch Hallgeneratoren und Oberflächenwellenoszillatoren. Solche Maßnahmen sind in den älteren CH-Patentanmeldungen 10 520/79—0, 10 521/79—1, 7 234/80—0, 7 235/80—1, 9 567/80—3 und 9 568/80—5 beschrieben und werden daher hier nicht näher erläutert.

**Patentansprüche**

1. Magnetkernloser Meßwandler zum berührungslosen Messen eines Meßstroms, mit einem den Meßstrom (1) führenden U-förmigen Flachleiter (12; 15), mit einem ersten Magnetfeldsensor (5), der in Nachbarschaft zur Oberfläche des Flachleiters (12; 15) und parallel zur Flachseite eines Schenkels (13; 17) desselben an einer ersten Meßstelle ($P_1$) dem vom Meßstrom (1) erzeugten magnetischen Außenfeld ($H_{a1}$, $H_{a2}$) ausgesetzt ist, mit einem zweiten Magnetfeldsensor (6), der parallel zur Flachseite des anderen Schenkels (14; 18) des Flachleiters (12; 15) angeordnet ist, wobei beide Magnetfeldsensoren (5, 6) auf der gleichen Flachseite des Flachleiters (12; 15) in einer gemeinsamen Ebene angeordnet sind, und mit einem an den ersten Magnetfeldsensor (5) und an den zweiten Magnetfeldsensor (6) angeschlossenen Meßkreis (9) zur Erzeugung eines elektrischen Ausgangssignals ($T_1$, $T_3$, $f_a$), wobei die Signale ($U_a$, $U_b$) beider Magnetfeldsensoren (5, 6) miteinander verarbeitet werden und das erzeugte elektrische Ausgangssignal ein analoges Maß für den Meßstrom (1) darstellt, dadurch gekennzeichnet, daß das Außenfeld ($H_{a2}$, $H_{a1}$) an der zweiten Meßstelle ($P_2$), an der der zweite Magnetfeldsensor (6) angeordnet ist, im Vergleich zu der ersten Meßstelle ($P_1$) entgegengesetzt gerichtet ist und daß die Magnetfeldsensoren (5, 6) im Bereich der Schenkel (13, 14; 17, 18, 20, 21) angeordnet sind.

2. Meßwandler nach Anspruch 1, dadurch gekennzeichnet, daß der Flachleiter (15) einen zweiten U-förmigen Teil (19) aufweist, daß die insgesamt vier parallelen Schenkel (17, 18, 20, 21) eine bifilare Wicklung bilden und daß die Magnetfeldsensoren (5, 6) jeweils zwischen einem Schenkel (17, 21) des einen U-förmigen Teils (16) und einem Schenkel (18, 20) des anderen, darüberliegenden U-förmigen Teils (19) angeordnet sind.

3. Meßwandler nach Anspruch 1 oder 2, dadurch gekennzeichnet, daß der Meßkreis (4) zur Überlagerung der Signale ($U_1$, $U_2$) der beiden Magnetfeldsensoren (2, 3) eingerichtet ist.

4. Meßwandler nach Anspruch 1 oder 2, wobei die Magnetfeldsensoren (5, 6) einem aus dem Außenfeld ($H_{a1}$, $H_{a2}$) und einem Hilfsfeld ($H_h$) bestehenden Magnetfeld ($H_1$, $H_2$) ausgesetzt sind, eine nichtlineare Übertragungskennlinie aufweisen und jeweils im Nulldurchgang des Magnetfeldes ($H_1$, $H_2$) einen Impuls erzeugen, dadurch gekennzeichnet, daß der Meßkreis (9) zur Erzeugung eines Ausgangssignals ($f_a$) eingerichtet ist, das dem Zeitabstand ($T_1$, $T_3$) zwischen einem Impuls ($U_a$) des ersten Magnetfeldsensors (5) und einem Impuls ($U_b$) des zweiten Magnetfeldsensors (6) entspricht.

5. Meßwandler nach einem der Ansprüche 1 bis 4, dadurch gekennzeichnet, daß die beiden Magnetfeldsensoren (5, 6) auf einem gemeinsamen Substrat angeordnet sind.

6. Meßwandler nach Anspruch 5, dadurch gekennzeichnet, daß auf dem Substrat zusätzlich mindestens eine Dünnfilmspule (7) angeordnet ist.

**Revendications**

1. Transducteur de mesure sans noyau magnétique pour la mesure sans contact d'un courant de mesure, comportant un conducteur plat (12, 15) en forme de U, véhiculant le courant de mesure (1), un premier détecteur de champ magnétique (5), qui au voisinage de la surface du conducteur plat (12, 15) et parallèlement à la face plate d'une branche (13; 17) de ce dernier et en un premier emplacement de mesure (P1), est soumis au champ magnétique extérieur ($H_{a1}$, $H_{a2}$) produit par le courant de mesure (1), un second détecteur de champ magnétique (6) qui est disposé parallèlement à la face plate de la seconde branche (14; 18) du conducteur plat (12; 15), les deux détecteurs de champ magnétique (5; 6) étant disposés sur la même face plane du conducteur plat (12; 15) dans un plan commun, et un circuit de mesure (9) raccordé au premier détecteur de champ magnétique (5) et au deuxième détecteur de champ magnétique (6) et servant à produire un signal électrique de sortie ($T_1$, $T_3$, $f_a$), les signaux ($U_a$, $U_b$) des deux détecteurs de champ magnétique (5; 6) étant traités conjointement et le signal électrique de sortie représentant une mesure analogique du courant de mesure (1), le signal électrique de sortie produit représentant une mesure analogique du courant de mesure (1), caractérisé en ce que le champ extérieur ($H_{a2}$, $H_{a1}$) est dirigé, au niveau du second point de mesure ($P_2$), où est disposé le deuxième capteur de champ magnétique (6), en sens opposé par rapport à ce qu'il est au premier point de mesure ($P_1$) et que les détecteurs de champ magnétique (5; 6) sont disposés dans la zone des branches (13, 14; 17, 18, 20, 21).

2. Transducteur de mesure selon la revendication 1, caractérisé en ce que le conducteur plat (15) possède une seconde partie (19) en forme de U, que l'ensemble des quatre branches parallèles (17, 18, 20, 21) forment un enroulement bifilaire et que les détecteurs de champ magnétique (5, 6) sont disposés respectivement entre une branche (17, 21) d'une partie en forme de U (16) et une branche (18, 20) de l'autre partie en forme de U (19) superposée.

3. Transducteur de mesure selon la revendication 1 ou 2, caractérisé en ce que le circuit de mesure (14)

5

est agencé pour réaliser la superposition des signaux ($U_1$, $U_2$) des deux détecteurs de champ magnétique (2, 3).

4. Transducteur de mesure selon la revendication 1 ou 2, dans lequel les détecteurs de champ magnétique (5, 7) sont soumis à un champ magnétique ($H_1$, $H_2$) constitué par le champ extérieur ($H_{a1}$, $H_{a2}$) et par un champ auxiliaire ($H_h$), possèdent une caractéristique de transmission non linéaire et produisent respectivement une impulsion lors du passage à zéro du champ magnétique ($H_1$, $H_2$), caractérisé en ce que le circuit de mesure (9) est agencé de manière à produire un signal de sortie ($f_a$) qui correspond à l'intervalle de temps ($T_1$ $T_3$) existant entre une impulsion ($U_a$) du premier détecteur de champ magnétique (5) et une impulsion ($U_b$) du second détecteur de champ magnétique (6).

5. Transducteur de mesure selon l'une des revendications 1 à 4, caractérisé en ce que les deux détecteurs de champ magnétique (5, 6) sont disposés sur un substrat commun.

6. Transducteur de mesure selon la revendication 5, caractérisé en ce qu'au moins une bobine (7) à couche mince et disposée en supplément sur le substrat.

## Claims

1. A magnetic core-less measuring transducer for the non-contact measurement of a current to be measured, comprising a U-shaped flat conductor (12; 15) carrying the current (1) to be measured, a first magnetic field sensor (5) which adjoining the surface of the flat conductor (12; 15) and parallel to the flat side of one limb (13; 17) thereof, at a first measuring location ($P_1$), is exposed to the external magnetic field ($H_{a1}$, $H_{a2}$) produced by the current (1) to be measured, a second magnetic field sensor (6) which is arranged parallel to the flat side of the other limb (14; 18) of the flat conductor (12; 15), both magnetic field sensors (5, 6) being arranged on the same flat side of the flat conductor (12; 15) in a common plane, and a measuring circuit (9) connected to the first magnetic field sensor (5) and to the second magnetic field sensor (6) for generating an electrical output signal ($T_1$, $T_3$, $f_a$), the signals ($U_a$, $U_b$) of both magnetic field sensors (5, 6) being processed together and the electrical output signal generated representing an analog measurement in respect of the current (1) to be measured, characterised in that the external field ($H_{a2}$, $H_{a1}$) at the second measuring location ($P_2$) at which the second magnetic field sensor (6) is arranged is of opposite direction in comparison with the first measuring location ($P_1$), and that the magnetic field sensors (5, 6) are arranged in the region of the limbs (13, 14; 17, 18, 20, 21).

2. A transducer according to claim 1 characterised in that the flat conductor (15) has a second U-shaped portion (19), that the total of four parallel limbs (17, 18, 20, 21) form a bifilar winding and that the magnetic field sensors (5, 6) are respectively arranged between a limb (17, 21) of the one U-shaped portion (16) and a limb (18, 20) of the other oppositely disposed U-shaped portion (19).

3. A transducer according to claim 1 or claim 2 characterised in that the measuring circuit (4) is arranged to superimpose the signals ($U_1$, $U_2$) of the two magnetic field sensors (2, 3).

4. A transducer according to claim 1 or claim 2 wherein the magnetic field sensors (5, 6) are exposed to a magnetic field ($H_1$, $H_2$) comprising the external field ($H_{a1}$, $H_{a2}$) and an auxiliary field ($H_h$), have a non-linear transmission characteristic and respectively produce a pulse in the passage through zero of the magnetic field ($H_1$, $H_2$), characterised in that the measuring circuit (9) is arranged to generate an output signal ($f_a$) which corresponds to the time interval ($T_1$, $T_3$) between a pulse ($U_a$) of the first magnetic field sensor (5) and a pulse ($U_b$) of the second magnetic field sensor (6).

5. A transducer according to one of claims 1 to 4 characterised in that the two magnetic field sensors (5, 6) are arranged on a common substrate.

6. A transducer according to claim 5 characterised in that at least one thin film coil (7) is additionally arranged on the substrate.

# Fig. 1

b

d

1

I

P1    Ha1

Ha2

P2

He

# Fig. 2

I

U1

1

2    H1

H2

3    U2

U

4

# Fig. 3

5

7    H1

1

8    H2

6

# Fig.4

1

5    7

I

Ih

# Fig. 5

H

Hm    Hh

+Ha

-Ha

t1    t2    t3    t4    t

T

T1    T2    T3    T4

Ua

Ub

# Fig. 6

5    Ua    Ih    fr

6    Ub

10    9    11

fa

# Fig. 7

# Fig. 9

# Fig. 8

# Fig. 11

# Fig. 10